Europäisches Patentamt

European Patent Office

Office européen des brevets

(11) Veröffentlichungsnummer: **0 066 881**
A2

(12) **EUROPÄISCHE PATENTANMELDUNG**

(21) Anmeldenummer: 82105006.9

(22) Anmeldetag: 08.06.82

(51) Int. Cl.³: **H 03 K 17/96**

(30) Priorität: 10.06.81 DE 3123022

(43) Veröffentlichungstag der Anmeldung: 15.12.82
Patentblatt 82/50

(84) Benannte Vertragsstaaten: **AT BE CH DE FR GB IT LI LU NL SE**

(71) Anmelder: **Pretzsch, Siegfried, Dürerstrasse 21a, D-5657 Haan 1 (DE)**

(72) Erfinder: **Pretzsch, Siegfried, Dürerstrasse 21a, D-5657 Haan 1 (DE)**

(74) Vertreter: **Hemmerich, Friedrich Werner, Patentanwälte HEMMERICH-MÜLLER-GROSSE-POLLMEIER Berliner Allee 41, D-4000 Düsseldorf 1 (DE)**

(54) Sensorschaltungsanordnung.

(57) Eine Sensorschaltung, die aus Tastfeldern (TF) gebildet wird, die auf die Vorderseite einer Scheibe (4) aus nicht leitendem Werkstoff (Glas) aufgebracht sind und aus diesen gegenüberliegend auf der Rückseite der Scheibe (4) befindlichen, Paaren von Flächenkontakten (KE, KA) die nebeneinanderliegend durch einen Luftspalt (LM) von einander getrennt und mit Schaltelementen von Schaltungseinheiten verbindbar sind. Die Länge des jeweiligen Luftspaltes (LM) zwischen den Paaren von Flächenkontakten (KE, KA) ist grösser bemessen als die entsprechende Länge (1) der Flächenkontakte selbst.

0066881

22 918 h.mar                                    08.06.1981

Pretzsch, Siegfried, D-5657 Haan

Sensorschalteranordnung

Die Erfindung bezieht sich auf eine Sensorschalteranordnung
bestehend aus, auf die Vorderseite einer Scheibe aus nichtleitendem Werkstoff aufgebrachten Tastfeldern und diesen gegenüberliegend auf der Rückseite der Scheibe befindlichen,
nebeneinanderliegenden Paaren von, durch einen Luftspalt getrennten Flächenkontakten, die mit Schaltelementen von Schaltungseinheiten verbindbar sind.

Bei bekannten Sensorschaltern dieser Art (US-PS 4056699,
DE-OS 2728188) wird das Tastfeld auf der Oberseite der Scheibe aus nichtleitendem Werkstoff hier einer Glasscheibe aus
einem leitenden Werkstoff gebildet, z.B. aus aufgedampftem
Metall. Diese Verwendung von leitendem Werkstoff erhöht die
Kapazität des von den beiden Flächenkontakten des Flächenkontaktpaares gebildeten Kondensators auf ein Maß, gegenüber dem
von den einzelnen Schaltelementen der Schaltungseinheit ausgehende sog. parasitäre Einflüsse den Sensorschalter nicht
mehr störend beeinflußen können. Voraussetzung dafür ist allerdings die Verwendung von z.T. aufwendigen Schaltelementen
mit entsprechend niedrigem Einflußpegel. Die Herstellung dieser bekannten Sensorschalter erfordert deshalb nicht nur den,
wegen mehr oder weniger großer Ausschußquoten beim Aufbringen
der Metallbedampfung auf die Glasscheibe hohen Aufwand für
diese aus hochwertigem legiertem Glas bestehenden Glasscheiben,
sondern auch einen, im Verhältnis ebenso hohen Aufwand für die
Schaltelemente der Schaltungseinheiten, die den erwähnten
niedrigen Einflußpegel aufweisen müssen.

Der Erfindung liegt die Aufgabe zugrunde, die Kapazität des
Sensorschalters wesentlich, d.h. um ein mehrfaches der Kapazität der bekannten Schalter zu erhöhen und damit die Möglich-

- 2 -

keit zu schaffen, auf das Aufbringen von leitendem Werkstoff
auf die Tastfelder insbesondere die Metallaufdampfung zu verzichten und damit den hohen Aufwand bei der Herstellung von
Glasplatten mit Tastfeldern zu vermeiden, da die Tastfelder in
solchen Fällen nur als Positionsmarkierung aufgedruckt werden
müssen. Des weiteren die Möglichkeit zu schaffen, Schaltelemente einfacher niederohmiger Bauart mit höherer Kapazität oder
solche mit höherem Toleranzbereich bei der Fertigung zu verwenden, die sich preiswerter herstellen lassen, da der entsprechend
höhere Störeinflußpegel solcher Elemente wegen des hohen Kapazitätsüberschusses des Schalters nicht störwirksam werden kann.

Diese Aufgabe wird dadurch gelöst, daß die Länge des jeweiligen
Luftspalts zwischen den Flächenkontaktpaaren größer bemessen ist
als die entsprechende Länge der Flächenkontakte selbst. Der Luftspalt kann dabei vorteilhafterweise die Form eines Maeanders aufweisen oder aber auch die Form einer Kurve z.B. einer Sägezahn-
Kurve aufweisen. Die Flächenkontaktpaare können dabei auf einer
Tragscheibe aufgebracht sein, wobei die Tragscheibe auf der Rückseite der Scheibe aus nichtleitendem Werkstoff mit dieser Scheibe
zugewandten Flächenkontaktpaaren aufliegt. Die Tragscheibe kann
aus einem flexiblen Werkstoff bestehen und mit der Rückseite der
Scheibe aus nichtleitendem Werkstoff durch Kleben verbunden sein.
Die Tragscheibe kann auch unter der Wirkung von Federn gegen die
Rückseite der Scheibe gedrückt werden, wobei die Federn als Paare
von Zylinderfedern ausgebildet sein können, die gleichzeitig die
elektrischen Leiter zwischen den Flächenkontakten und den Schaltelementen bilden. Tragscheibe und Flächenkontakte können dabei
mit einem Isolierwerkstoff umhüllt sein.

Die hohe Kapazität des erfindungsgemäß ausgebildeten Sensorschalters bringt es mit sich, daß der Schalter außerordentlich sicher
schaltet. Die große Kapazität pro Flächeneinheit bringt eine von
Temperatur- und Feuchtigkeitseinflüssen wesentlich unabhängigere

gleichbleibende Tastempfindlichkeit mit sich und erlaubt es,
die Tastflächen geometrisch so zu gestalten, daß die Tast-
Schaltwirkung nur unmittelbar über der Kontaktfläche eintritt.
Bei gegebener Impulsfolgefrequenz läßt sich mithilfe entsprechender elektronischer Schaltung gewährleisten, daß der Schalter
auch noch einwandfrei schaltet, wenn sich über den markierten
Tastfeldern auf der Glasoberseite ein Wasserfilm bildet, wie
dies z.B. bei Glaskochfeldern, aber auch bei Schaltern im
Industrie-Laboratorium und Sanitäranlagenbereich der Fall sein
kann. Es besteht ferner die Möglichkeit bei Glaskochfeldern,
die mit einer Metalleinfassung versehen sind, ein unbeabsichtigtes Einschalten des Kochfeldes durch auf der Glasoberfläche
aufstehende Flüssigkeiten durch entsprechende Schaltungsanordnungen dadurch zu verhindern, daß in diesem Fall automatisch
die Aus-Schaltung ausgelöst wird.

Die Erfindung wird anhand der in der Zeichnung dargestellten
Ausführungsbeispiele näher erläutert. In der Zeichnung zeigen
Fig. 1 die bekannte Ausbildung und Anordnung der Flächenkontakte
      auf einer Glasplatte von unten gesehen,
Fig. 2 die Ausbildung und Anordnung der Flächenkontakte nach
      der Erfindung entsprechend Fig. 1,
Fig. 3 die Seitenansicht von Fig. 2,
Fig. 4 die Seitenansicht von Fig. 2 in einer abweichenden Anordnung
Fig. 5 ein Schaltschema für die Ausbildung nach Fig. 2,
Fig. 6 ein anderes Schaltschema für die Ausbildung nach Fig. 2
      und
Fig. 7 die Draufsicht einer anderen Ausbildung der Anordnung
      nach Fig. 2

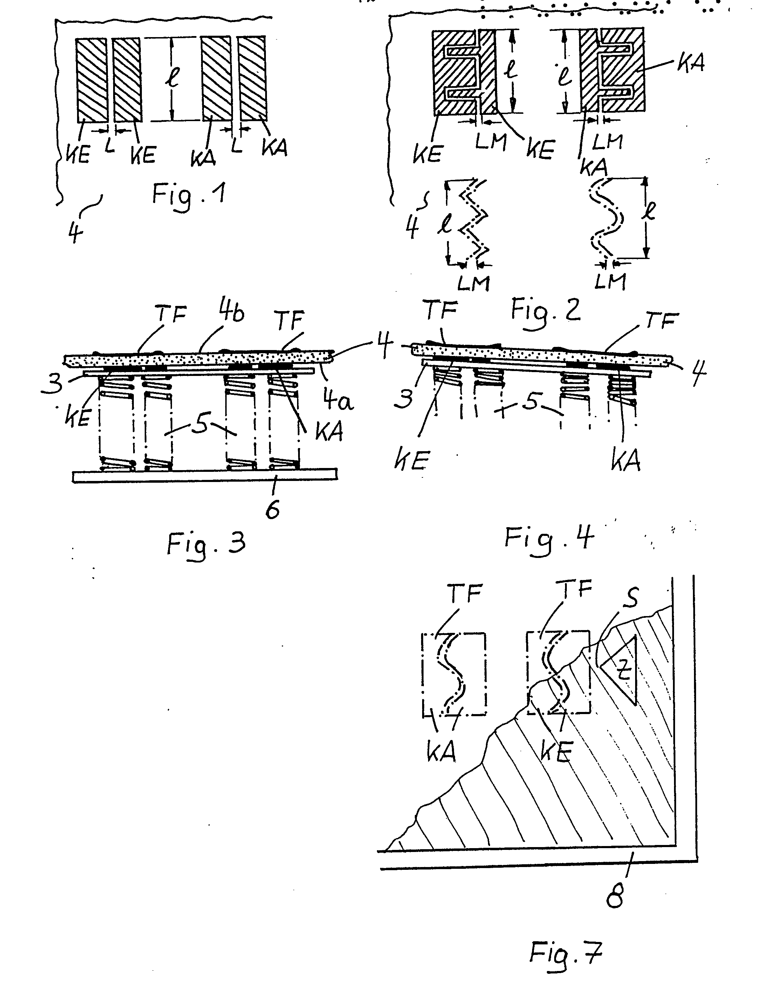

Wie aus Fig. 1 zu ersehen, sind bei den bekannten Sensorschaltanordnungen die Kontaktflächen KE für den Ein-Schalter und KA
für den Aus-Schalter durch Luftspalte L von der Länge 1 voneinander getrennt, wobei die Länge des Luftspaltes der Länge der Kontaktflächen KE bzw. KA entspricht.

Die Kontaktflächen KE bzw. KA der Anordnung nach Fig. 2 sind durch Luftspalte LM von einander getrennt, deren Länge, wie ersichtlich, einem mehrfachen der Länge l der Kontaktflächen selbst entspricht, gleichgültig, ob sie wie in vollen Linien dargestellt, Mäanderform oder wie strichpunktiert wiedergegeben in Sägezahn- oder bspw. Sinusform verlaufen.

Beim Ausführungsbeispiel nach Fig. 3 sind die Kontaktflächen KE bzw. KA jeweils gemeinsam auf eine Tragscheibe 3 aufgebracht und liegen an der Unterseite 4 a einer Glasscheibe 4 an, auf deren Oberseite 4 b die Tastfelder TF durch Aufdrucken oder Aufbringen einer Folie markiert sind. Unterhalb der Tragscheiben 3 sind beim Ausführungsbeispiel Schraubenfederpaare 5 mit ihren Stirnseiten befestigt, die mit den anderen Stirnseiten auf dem Träger 6 einer Schaltungseinheit aufstehen, und an diesem befestigt sind. Die Schraubenfedern 5 stellen dabei gleichzeitig die elektrische Leitungsverbindung zwischen den Flächenkontakten KE bzw. KA und den (nicht dargestellten) Schaltelementen der auf dem Träger 6 befindlichen Schaltungseinheit dar. Die Anordnung der Tragscheiben 3 auf den Schraubenfederpaaren 5 bringt, wie aus Fig. 4 ersichtlich, den zusätzlichen Vorteil mit sich, daß auch bei Winkelunterschieden zwischen der Lage der Kontaktflächen 3 bzw. des Trägers 6 und der Glasscheibe 4 ein planes Anliegen der Kontaktflächen an der Unterseite 4a der Glasplatte 4 gewährleistet ist.

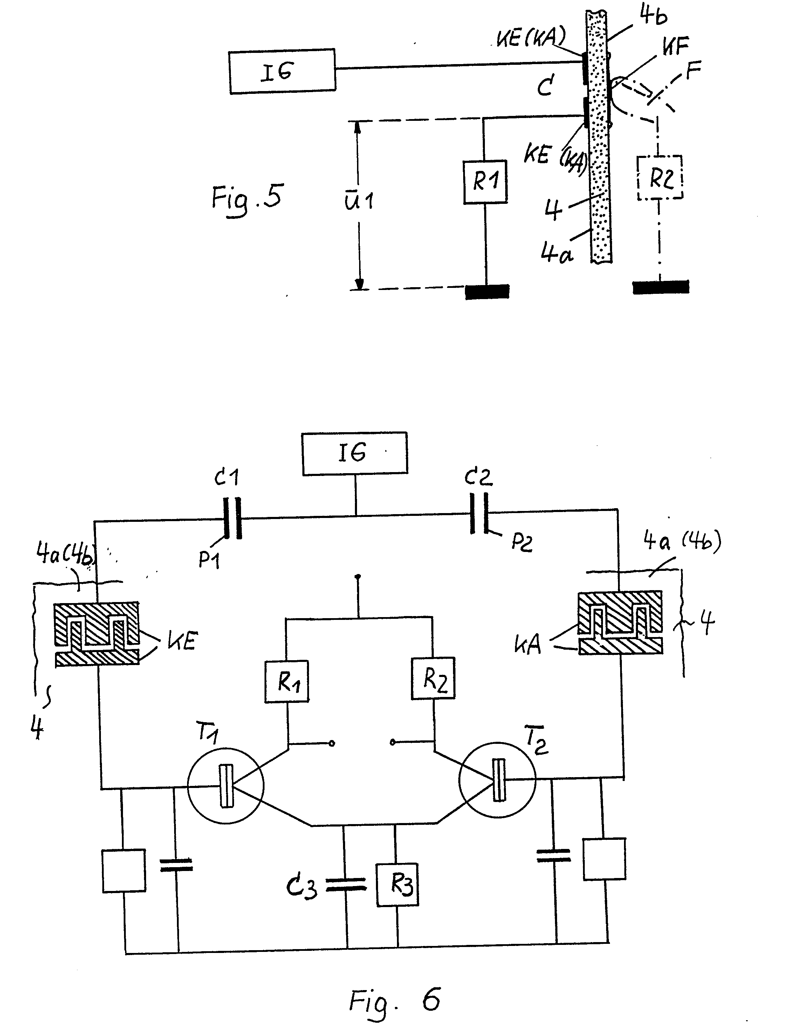

Aus der Schaltungsanordnung nach Fig. 5 geht hervor, daß die Kontaktflächenpaare KE bzw. KA einen Kondensator C bilden, der zusammen mit einem Widerstand R 1 eine Reihenschaltung bildet. Diese Reihenschaltung liegt an einer Impulsfolgefrequenz unter 1 KHz mit steilen Anstiegsflanken. Entsprechend dem kapazitiven Widerstand von C fällt am Widerstand R 1 eine Spannung U 1 ab. Beim Auflegen des Fingers F auf die Oberseite 4 b der Glasplatte 4 entsteht eine Kontaktfläche KF (Fingerfläche) direkt über den Kontaktflächenpaaren KE bzw. KA. Die dabei entstehende ohm'sche Verbindung mit dem Widerstand R 2 zur Erde parallel zu dem Widerstand R 1, bei der der Widerstand R 2 um ein vielfaches kleiner ist als der Widerstand R 1 führt zu einer starken Verringerung der Spannung U 1. Diese Spannungsänderung wird in bekannter Weise als Schaltkriterium für den Sensorschalter verwendet.

Wie aus Fig. 6 hervorgeht, sind bei diesen Ausführungsbeispielen die Tast-Kondensatorflächen KE und KA kapazitiv über die Kondensatoren C1 und C2 an den Impulsgenerator IG angekoppelt. Der aus T1 und T2 bestehende Differenzverstärker weist einen Widerstand im Emitterkreis auf, dessen Gegenkopplungswirkung ein steiles Schaltkriterium für die Aus- und Einschaltung gewährleistet und durch diese Eigenschaft die Beeinflussung der Schaltfunktion durch Wasserfilm auf den Tastflächen herabgemindert wird.

Ein parallel zu diesem Gegenkopplungswiderstand R3 liegender KOndensator C3 bevorzugt die Verstärkung des hohen Frequenzanteiles und verringert damit die Beeinflussung der Schaltung durch hohe Umgebungstemperaturen und ebenfalls Feuchtigkeit auf der Oberseite 4B oder der Unterseite 4A der Glasscheibe 4.

Durch die Anwendung des Kondensators C3 und die besondere geometrische Ausbildung der Kondensatorkontaktflächen KE udn KA verringert sich der Einfluß von parasitären Kapazitäten, die durch die beteiligten Bauelemente gegeben sind, auf die gewollte Funktion der Schaltung und gestattet damit den Einsatz von Bauelementen mit größeren Datentoleranzen.

des Ein-Schalters ein einzelner Flächenkontakt Z des zugehörigen Aus-Schalters mit den Flächenkontakten KA zugeordnet. Dieser einzelne Flächenkontakt Z weist die Form eines Dreiecks auf, das mit einer Spitze S auf eine Längsaußenseite des Flächenkontaktpaares KE gerichtet ist, wobei der Abstand der Spitze S von der Längsaußenseite des Flächenkontaktes KE etwa der Breite des Luftspaltes L des Flächenkontaktpaares KE entspricht. Bildet sich auf der Oberseite 4b der Glasscheibe 4, wie schraffiert angedeutet, eine zusammenhängende Wasserbrücke W zwischen dem metallischen Rahmen 8 und den strichpunktiert angedeuteten Tastfeldern TF des Ein-Schalters der Kontaktflächen KE, dann ist gewährleistet, daß der angeschlossene Verbraucher trotz der Ver-

— 6 —

bindung zwischen dem metallischen Rahmen 8 und den Tastfeldern
des Ein-Schalters zuverlässig ausgeschaltet wird.

Die Schaltungen sind immer so konzipiert, daß immer dann ausgeschaltet wird, wenn das Tastenfeld TF des Ausschalters oder
aber die Tastenfelder TF des Aus- und Einschalters gleichzeitig
berührt werden. Das wird erreicht durch eine Differenzierschaltung zwischen Einschaltspeicher und Tastschaltung und einer
Widerstandskopplung der Tastschaltung an dem Ausschaltspeicher.

Durch eine besondere Schaltungsmaßnahme in der Gesamtschaltung
wurde gewährleistet, daß aaxdiexSchal ein an die Schaltung
angeschlossener  Verbraucher nach 5 Sekunden ausgeschaltet wird,
sofern sich Wasserbrücken zwischen den Tastenfeldern und dem
Schutzleiterpotential (Rahmen bei Kochfeldern) bilden. Das wird
erreicht durch ein elektronisches Zeitglied aus Widerstand und
Kondensator.

22 918 h.mar                                    08.06.1981

Pretzsch, Siegfried, D-5657 Haan

Patentansprüche

1. Sensorschalteranordnung bestehend aus, auf die Vorderseite einer Scheibe aus nichtleitendem Werkstoff (Glas) aufgebrachten Tastfeldern und diesen gegenüberliegend, auf der Rückseite der Scheibe befindlichen, nebeneinanderliegenden Paaren von, durch einen Luftspalt getrennten Flächenkontakten, die mit Schaltelementen von Schaltungseinheiten verbindbar sind,
d a d u r c h   g e k e n n z e i c h n e t ,
daß die Länge des jeweiligen Luftspalts zwischen den Flächenkontaktpaaren (KE bzw. KA) größer bemessen ist, als die entsprechende Länge (1) der Flächenkontakte selbst.

2. Sensorschalteranordnung nach Anspruch 1,
d a d u r c h   g e k e n n z e i c h n e t ,
daß der Luftspalt (LM) die Form eines Mäaenders aufweist.

3. Sensorschalteranordnung nach Anspruch 1,
d a d u r c h   g e k e n n z e i c h n e t ,
daß der Luftspalt die Form einer Sägezahn-Kurve oder dgl. aufweist.

4. Sensorschalteranordnung nach einem oder mehreren der Ansprüche 1 - 3,
d a d u r c h   g e k e n n z e i c h n e t ,
daß die Flächenkontaktpaare (KE, KA) auf eine Tragscheibe (3) aufgebracht sind, die auf der Rückseite der Scheibe (4) aus nichtleitendem Werkstoff mit dieser zugewandten Flächenkontaktpaaren (KE) aufliegt.

5. Sensorschalteranordnung nach Anspruch 4,
d a d u r c h   g e k e n n z e i c h n e t ,
daß die Tragscheibe (3) aus flexiblem Folienwerkstoff besteht.

- 2 -

6. Sensorschalteranordnung nach den Ansprüchen 4 und/oder 5,
   d a d u r c h   g e k e n n z e i c h n e t ,
   daß die Tragscheibe (3) mit der Unterseite (4a) der Scheibe (4) in ansich bekannter Weise durch Kleben verbunden ist.

7. Sensorschalteranordnung nach Anspruch 4,
   d a d u r c h   g e k e n n z e i c h n e t ,
   daß die Tragscheibe (3) unter der Wirkung von Federn (5) gegen die Rückseite (4a) der Scheibe (4) gedrückt wird.

8. Sensorschalteranordnung nach Anspruch 7,
   d a d u r c h   g e k e n n z e i c h n e t ,
   daß die Federn als Paare von gleichzeitig die elektrischen Leiter zwischen den Kontaktfeldern (KE, KA) und den Schaltungselementen bildenden Schraubenfedern (5) ausgebildet sind.

9. Sensorschalteranordnung nach Anspruch 8,
   d a d u r c h   g e k e n n z e i c h n e t ,
   daß die Schraubenfedern(5) mit ihren Stirnseiten einerseits an der Tragscheibe (3) anliegen und andererseits auf dem Träger (6) der Schaltungseinheit aufstehend mit diesem verbunden sind.

10. Sensorschalteranordnung nach einem oder mehreren der Ansprüche 5 - 9,
    d a d u r c h   g e k e n n z e i c h n e t ,
    daß die Tragscheibe (3) und die Kontaktfelder (KE, KA) mit einem Isolierwerkstoff umhüllt sind.

11. Sensorschalteranordnung nach einem oder mehreren der Ansprüche 1-10,
    d a d u r c h   g e k e n n z e i c h n e t ,
    daß dem Flächenkontaktpaar (KE) eines Ein-Schalters ein einzelner Flächenkontakt (Z) des zugehörigen Aus-Schalters zu-

- 3 -

geordnet ist, der die Form eines Dreiecks aufweist, das mit einer Spitze (S) auf eine Längsaußenseite des Flächenkontaktpaares (KE) des Ein-Schalters gerichtet ist, wobei der Abstand der Dreieckspitze (S) von der Längsseite etwa der Breite (L) des Luftspaltes des Flächenkontaktpaares (KE) entspricht.

12. Sensorschalteranordnung nach einem oder mehreren der Ansprüche 1-11,
d a d u r c h   g e k e n n z e i c h n e t,
daß bei Kopplung der den Flächenkontakten (KE und KA) der Ein- und Aus-Schalter zugeordneten Kondensatoren (C1 und C2) mit einem Impulsgenerator (IG), dessen Impulsfolgefrequenz steile Anstiegsflanken aufweist, zwischen beide Schalter ein Differenzverstärker (T1, T2) geschaltet ist, der einen Gegenkopplungswiderstand (R3) und einen parallel zu diesem geschalteten Kondensator (C3) aufweist.

0066881 918

Fig. 1

Fig. 2

Fig. 3

Fig. 4

Fig. 7

2.2.918
0066881

Fig. 5

Fig. 6